# EUROPEAN PATENT APPLICATION

(11) **EP 1 471 634 A1**
(43) Date of publication of application: **27.10.2004**
(21) Application number: 04076156.1
(22) Date of filing: 15.04.2004
(51) Int. Cl.: H03G 3/20

(54) **Radio receiver with optimized multiple variable gain circuits**

(30) Priority: 22.04.2003 US 420436
(71) Applicant: Delphi Technologies, Inc., Troy, MI 48007 (US)
(72) Inventor: Dockemeyer, Robert J. Jr, Kokomo, IN 46901 (US); Dyson, William E., Carmel, IN 46032 (US)
(74) Representative: Denton, Michael John

(57) **Abstract**

A digital radio receiver (12) is provided having first and second inputs (14 and 16) for receiving first and second signals. The radio receiver (12) also includes a first variable gain circuit (40) for adjusting one of gain and attenuation of the first input signal, and a second variable gain circuit (60) for adjusting one of gain and attenuation of the second input signal. A detector (52) is coupled to an output for one of the first and second variable gain circuits (40 and 60) for detecting signal strength, and an offset circuit (54) is coupled to the first and second variable gain circuits (40 and 60). The offset circuit (54) controls at least one of the first and second variable gain circuits (40 and 60) based on the detected signal strength and offset.

## Description

### Technical Field

The present invention generally relates to radio receivers and, more particularly, to optimizing the processing of multiple signals input to a receiver radio.

### Background of the Invention

Automotive vehicles are commonly equipped with audio radios for receiving wireless broadcast radio frequency (RF) signals, processing the RF signals, and broadcasting audio information to passenger(s) in the vehicle. More recently, satellite based digital audio radio (SDAR) services have become available that offer digital radio service covering a large geographic area, such as North America. Currently, a couple of satellite based digital audio radio services are available in North America, both of which generally employ either geo-stationary orbit satellites or highly elliptical orbit satellites that receive uplinked programming which, in turn, is broadcast directly to digital radios in vehicles on the ground that subscribe to the service. Additionally, a number of terrestrial (ground based) transmission repeaters are currently employed in certain areas susceptible to satellite signal blockage in an attempt to provide a clean and uninterrupted radio signal broadcast. Each vehicle subscribing to the digital service generally includes a digital radio having a receiver and a pair of antennas for receiving the satellite and terrestrial signal broadcasts.

In some multiple antenna systems, such as the satellite based digital audio radio services systems, there exists the potential for each antenna to have different dynamic signal conditions on each antenna path. The different dynamic signal conditions may be due, at least in part, to antenna pattern, gain differences, and/or signal blockage. Additionally, some systems may have multiple signal modulation types (e.g., QPSK, FSK, COFDM) that have different signal parameter characteristics. The different dynamic signal conditions can be addressed by utilizing separate detector circuits associated with each antenna path to control the amount of automatic gain control (AGC) on the corresponding antenna path. To minimize cost, it has been proposed to utilize a single detector circuit that controls the amount of automatic gain control on each antenna path, simultaneously, especially for discrete circuit designs. Such designs offer the advantage that the isolation between multiple paths are kept constant. However, the antenna path with the detector may trigger too early or too late for the other antenna paths. Additionally, a secondary path may not be optimized because the desired signals for the secondary path are different from the primary path, thereby decreasing overall system performance.

Accordingly, it is therefore desirable to provide for a multiple antenna system that optimizes the signals received from multiple antenna paths. In particular, it is desirable to provide for a radio receiver that optimizes the signals received from multiple antenna paths, and employs a single detector circuit to control multiple signal paths, so as to enhance overall system performance.

### Summary of the Invention

In accordance with the teachings of the present invention, a radio receiver is provided having a first input for receiving a first signal, and a second input for receiving a second signal. The radio receiver also includes a first variable gain circuit for adjusting one of gain and attenuation of the first input signal, and a second variable gain circuit for adjusting one of gain and attenuation of the second input signal. A detector is coupled to an output of one of the first and second variable gain devices for detecting signal strength at the output. The receiver further includes an offset circuit coupled to the first and second variable gain circuits. The offset circuit controls the first and second variable gain circuits based on the detected signal strength and an offset.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a block diagram illustrating a vehicle equipped with a digital radio receiver for receiving RF signals on multiple antenna paths;
FIG. 2 is a block diagram further illustrating the RF tuner and microcontroller shown in FIG. 1;
FIG. 3 is a circuit diagram illustrating the offset circuit in FIG. 2 according to one embodiment;
FIG. 4 is a flow diagram illustrating a method of adjusting the offset circuit of FIG. 3; and
FIG. 5 is a circuit diagram illustrating an offset circuit according to another embodiment.

### Description of the Preferred Embodiments

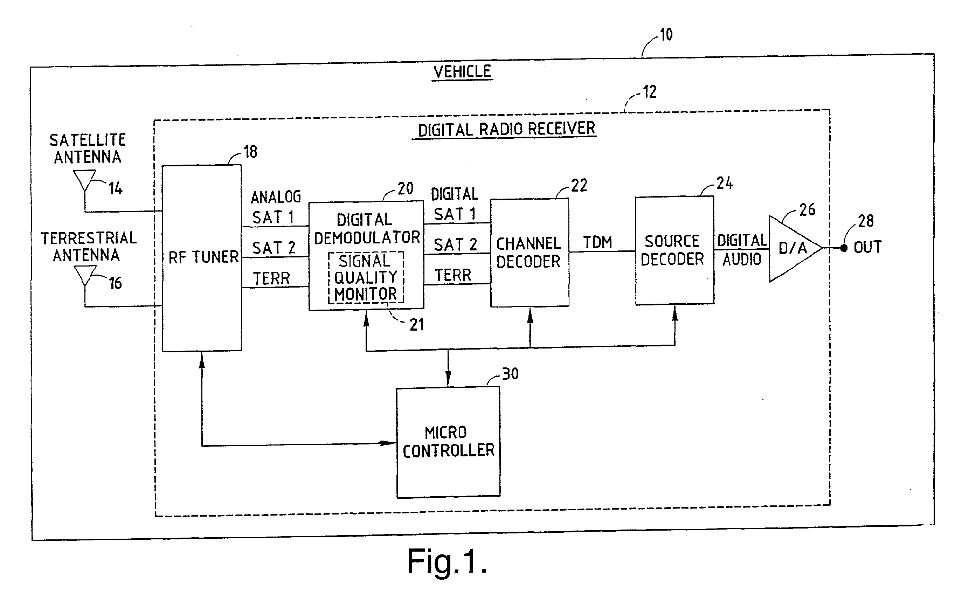

Referring to FIG. 1, a vehicle 10 is generally illustrated having a digital radio receiver 12 for receiving RF signal broadcasts of a satellite based digital audio radio service (SDAR). The vehicle 10 generally includes a satellite antenna 14 for receiving RF signals broadcast from satellite based transmitters. Additionally, the vehicle 10 is also shown equipped with a terrestrial antenna 16 for receiving RF signals broadcast from terrestrial (ground based) transmitters (repeaters). One of the satellite antenna 14 and terrestrial antenna 16 provides a primary signal path, while the other of satellite antenna 14 and terrestrial antenna 16 provides a secondary signal path. While satellite and terrestrial based antennas 14 and 16, respectively, are shown and described herein, it should be appreciated that the vehicle 10 may be equipped with two or more antennas for receiving wireless broadcast signals on two or more antenna paths employing variable gain circuits which are controlled by way of an offset circuit to optimize the performance of the radio receiver 12.

The digital radio receiver 12 is configured to receive and unscramble the digital data signals received by the satellite and terrestrial antennas 14 and 16, respectively. The digital radio receiver 12 includes an RF tuner 18 having antenna inputs for receiving RF signals received by each of the satellite antenna 14 and terrestrial antenna 16. The RF tuner 18 selects a frequency bandwidth (channel) of digital audio and/or data to pass each of the RF signals (SAT1, SAT2, and TERR) within a tuned frequency bandwidth. The digital radio receiver 12 also includes a digital demodulator circuit 20 which receives analog signals output from RF tuner 18 and creates demodulated digital signals (SAT1, SAT2, and TERR). The digital demodulator 20 includes a signal quality monitor 21 for monitoring the signal quality of each channel. The signal quality monitor 21 may monitor bit error rate (BER) and/or signal-to-noise ratio of the digital signals. The digital radio receiver 12 also includes a channel decoder 22 that creates a time division multiplexed (TDM) data stream, and a source decoder circuit 24 that selects desired audio and/or data information contained within the TDM data stream. The selected information is passed onto a digital-to-analog converter 26 which generates an analog output signal (OUT) at output 28. The digital radio receiver 12 further includes a microcontroller 30 for communicating with the RF tuner 18, digital demodulator 20, channel decoder 22, and source decoder 24, by way of a data communication bus or other data communication path.

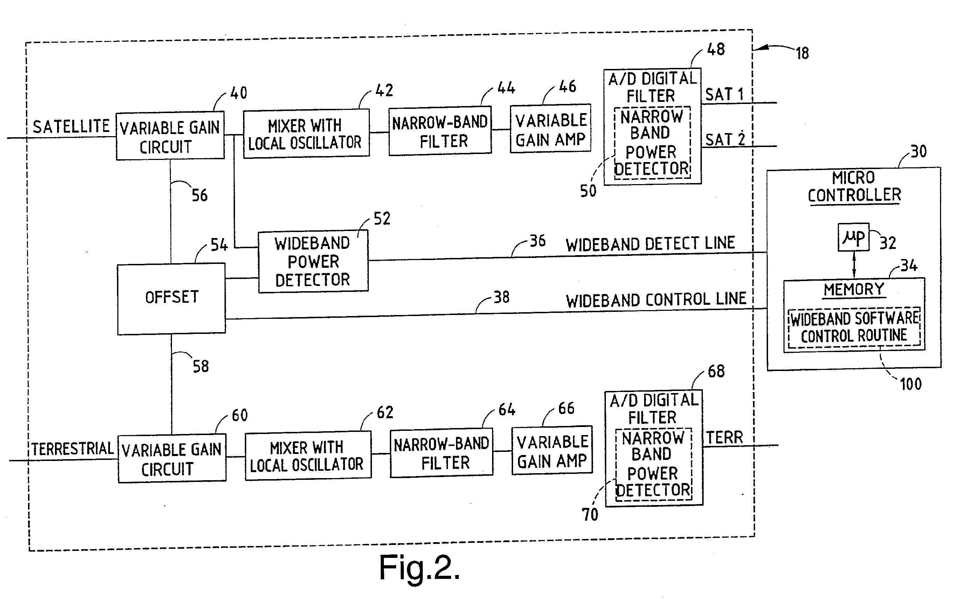

Referring to FIG. 2, the RF tuner 18 and microcontroller 30 are further illustrated therein employing an offset circuit 54 according to one embodiment of the present invention. The RF tuner 18 includes a first variable gain circuit 40 for receiving the satellite broadcast signals from satellite antenna 14. The satellite broadcast signals are considered the primary signals according to the embodiment shown and described herein. The first variable gain circuit 40 applies a gain factor to the primary signals. The first variable gain circuit 40 may provide positive gain (amplification) or negative gain (attenuation). The amount of gain is controlled in response to a gain control signal on line 56. The RF tuner 18 also includes a mixer 42 having a local oscillator, a narrow band filter 44, and a variable gain amplifier 46. The output of variable gain amplifier 46 is processed by an analog-to-digital filter 48 which includes a narrow band power detector 50.

The RF tuner 18 similarly includes a second variable gain circuit 60 for receiving terrestrial broadcast signals received on the terrestrial antenna 16. The terrestrial broadcast signals are considered the secondary signals in the embodiment shown and described herein. The second variable gain circuit 60 applies a gain factor to the secondary signals. The second variable gain circuit 60 may provide positive gain (amplification) or negative gain (attenuation). The amount of gain is controlled in response to a gain control signal on line 58. Coupled to the output of the second variable gain circuit 60 is a mixer 62 having a local oscillator, a narrow band filter 64, and a variable gain amplifier 66. The output of the variable gain amplifier 66 is applied to an analog-to-digital filter 68 which includes a narrow band power detector 70.

The RF tuner 18 further includes a wide band power detector 52 and an offset circuit 54 according to the present invention. The wide band power detector 52 detects the sum total power signal strength of the primary signals output from the first variable gain circuit 40. The signal strength may include signal power measured in decibels (dB). The wide band power detector 52 outputs the detected signal strength of the primary signal to microcontroller 30 via wide band detect line 36.

The offset circuit 54 controls the amount of offset provided in primary and secondary gain control signals applied on control lines 56 and 58, respectively. According to one embodiment, the microcontroller 30 controls the gain signal to be applied to the first variable gain circuit 40 via wide band control line 38. The offset circuit 54 in turn controls the offset in gain control signals applied on lines 56 and 58. It should be appreciated that by controlling the amount of offset on lines 56 and 58, the RF tuner 18 of the present invention advantageously is able to optimize the performance of the digital radio receiver 12 without requiring duplicative power detectors.

The microcontroller 30 includes a microprocessor 32 and memory 34. The microprocessor 32 may include a conventional microprocessor having the capability for processing algorithms and data as described herein. The memory 34 may include read-only memory (ROM), random access memory (RAM), flash memory, and other commercially available volatile and nonvolatile memory devices. Stored within memory 34 and processed by microprocessor 32 are one or more routines including a wide band software control routine 100 for controlling the offset circuit 54 as described herein.

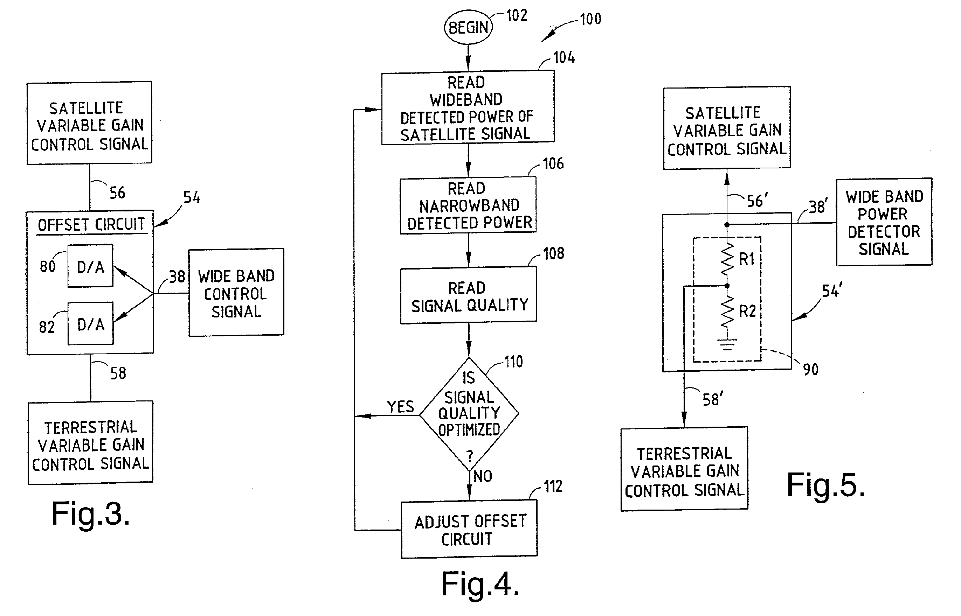

Referring to FIG. 3, the offset circuit 54 is illustrated in a digital configuration according to one embodiment of the present invention. The offset circuit 54 includes a first digital-to-analog converter 80 and a second digital-to-analog converter 82. The offset circuit 54 receives the wide band control signal on line 38 from microcontroller 30 which controls the amount of offset between the first and second digital-to-analog converters 80 and 82. The first and second digital-to-analog converters 80 and 82 may be configured with a predetermined offset applied to the variable gain control signal on lines 56 and 58. In one embodiment, the offset may include a voltage offset, such as the proportion of voltage applied to the variable gain signals in lines 56 and 58, relative to each other. Alternately, the offset may include a current signal. According to other embodiments, the offset may include an attack/decay time, or a combination of any of voltage, current, and time.

In lieu of preconfigured digital-to-analog converters 80 and 82, it should be appreciated that the first and second digital-to-analog converters 80 and 82 may be adjustable via the wide band control signal generated by microcontroller 30. By controlling the proportion of the output from the digital-to-analog converters 80 and 82, the signals on control lines 56 and 58 for controlling the first and second variable gain circuits 40 and 60, respectively, may be adjusted to optimize performance of the radio receiver 12.

Referring to FIG. 4, a method (routine) 100 is illustrated for adjusting the offset circuit to optimize signal quality according to one embodiment of the present invention. The method 100 begins at step 102 and proceeds to step 104 to read the wide band detected power signal strength of the satellite (primary) signal. Next, in step 106, method 100 reads the narrow band detected power signal strength for both of the primary and secondary signals. The signal quality is then read in step 108. The signal quality may be measured by monitoring the bit error rate and/or signal-to-noise ratio of the digital signals. Method 100 determines if the signal quality is optimized in decision step 110. It should be appreciated that a determination of whether the signal quality is optimized may include comparing signal quality to a predetermined signal quality, or may include adjusting parameters, including parameters of the offset circuit, to check for an improved signal quality response. If the signal quality is determined to be optimized, method 100 returns to step 104. If the signal quality is determined not to be optimized, method 100 proceeds to step 112 to adjust the offset circuit. Adjustment of the offset circuit may include an incremental adjustment of the offset to increase optimization of the signal quality. By repeating method 100, the signal quality may be more fully optimized to provide for enhanced performance of the digital radio receiver 12.

Referring to FIG. 5, an offset circuit 54' is illustrated according to another embodiment of the present invention. The offset circuit 54' receives a control signal on a control line 38' which is the output of the wide band power detector. According to this embodiment, the wide band power detector output is directly input to the offset circuit 54', thereby eliminating the use of the microcontroller 30. The offset circuit 54' includes first and second series connected resistors R1 and R2. Resistors R1 and R2 are selected so as to determine the amount of offset provided with gain control signals applied on the variable gain control lines 56' and 58'. By selecting the proportion of resistance of resistors R1 and R2, an offset value proportional to the ratio of resistance R1/R2 may be provided. It should be appreciated that the resistors R1 and R2 may be replaced with an adjustable potentiometer which allows for adjustment of the offset value. According to this configuration, the resistors R1 and R2 may be preconfigured to provide a predetermined offset, or may be adjusted to select a new offset value. It should further be appreciated according to this embodiment that the resistors R1 and R2 may be selected to provide an offset current, or may otherwise be configured to provide an attack/decay time as the offset, or a combination of any of a voltage, current, and time.

Accordingly, the radio receiver 12 according to the present invention advantageously employs an offset circuit 54 or 54' that provides an offset to first and second variable gain circuits 40 and 60 associated with first and second inputs. Thus, the first and second variable gain circuits 40 and 60 may be controlled based on the offset, in addition to detected signal strength in one of the primary signals. The presence of the offset circuit 54 or 54' allows for adjustments to the variable gain circuits 40 and 60 so as to optimize signal performance, while reducing the number of power detectors that may be otherwise required.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. A radio receiver (12) comprising:
a first input (14) for receiving a first signal;
a second input (16) for receiving a second signal;
a first variable gain circuit (40) for adjusting one of gain and attenuation of the first signal;
a second variable gain circuit (60) for adjusting one of gain and attenuation of the second signal;
a detector (52) coupled to an output of one of the first and second variable gain circuits (40) for detecting signal strength at the output of the one of the first and second variable gain circuits (40); and
an offset circuit (54) coupled to the first and second variable gain circuits (40 and 60), wherein the offset circuit (54) controls the first and second variable gain circuits (40 and 60) based on the detected signal strength and an offset.

2. The receiver as defined in claim 1 further comprising a controller (30) for controlling the offset circuit (54) to adjust at least one of the first and second variable gain circuits (40 and 60).

3. The receiver as defined in claim 1, wherein the first signal comprises a primary RF signal and the second signal comprises a secondary RF signal.

4. The receiver as defined in claim 1, wherein the offset circuit (54) controls automatic gain control in each of the first and second variable gain circuits (40 and 60).

5. The receiver as defined in claim 1, wherein the first and second inputs (14 and 16) each comprise an antenna.

6. The receiver as defined in claim 1, wherein the first signal comprises a digital satellite broadcast signal, and the second signal comprises a terrestrial broadcast signal.

7. The receiver as defined in claim 1, wherein the radio receiver (12) is located on a vehicle (10).

8. The receiver as defined in claim 1, wherein the receiver (12) is a digital receiver.

9. The receiver as defined in claim 1, wherein the offset circuit (54) comprises first and second digital-to-analog converters (80 and 82).

10. The receiver as defined in claim 1, wherein the offset comprises a voltage offset.

11. The receiver as defined in claim 10, wherein the offset circuit (54) further comprises first and second resistors (R1 and R2) coupled to provide the voltage offset.

12. A radio receiver (12) comprising:
a first input (14) for receiving a first signal;
a second input (16) for receiving a second signal;
a first variable gain circuit (40) for adjusting one of gain and attenuation of the first input signal;
a second variable gain circuit (60) for adjusting one of gain and attenuation of the second input signal;
a detector (52) coupled to an output of one of the first and second variable gain circuits (40) for detecting signal strength of the output, wherein the first and second variable gain circuits (40 and 60) are adjusted as a function of the signal strength; and
an offset circuit (54) coupled to the first and second variable gain circuits (40 and 60) for providing first and second gain control inputs, wherein the offset circuit (54) controls the first and second gain control inputs applied to the first and second variable gain circuits as a function of the offset.

13. The receiver as defined in claim 12 further comprising a controller (30) for controlling the offset circuit (54) to adjust at least one of the first and second variable gain circuits (40 and 60).

14. The receiver as defined in claim 12, wherein the receiver (12) is a digital receiver.

15. The receiver as defined in claim 14, wherein the first signal comprises a digital satellite broadcast RF signal, and the second signal comprises a terrestrial broadcast RF signal.

16. The receiver as defined in claim 12, wherein the first and second inputs (14 and 16) each comprise an antenna, and the offset circuit (54) is provided in a tuner (18).

17. The receiver as defined in claim 12, wherein the radio receiver (12) is located on a vehicle (10).

18. The radio receiver as defined in claim 12, wherein the offset comprises a voltage offset.

19. The receiver as defined in claim 18, wherein the offset circuit (54) comprises first and second resistors (R1 and R2) coupled to provide the voltage offset.

20. The receiver as defined in claim 12, wherein the offset circuit (54) comprises first and second digital-to-analog converters (80 and 82).
